# EUROPEAN PATENT SPECIFICATION

(11) **EP 0 809 676 B1**
(45) Date of publication and mention of the grant of the patent: **11.04.2001**
(21) Application number: 96904345.4
(22) Date of filing: 12.02.1996
(51) Int. Cl.: C08L 77/00, C08L 77/02, C08L 77/06

(54) **POLYAMIDE 4.6 COMPOSITION**
POLYAMID 4.6 ZUSAMMENSETZUNG
COMPOSITION A BASE DE POLYAMIDE 4.6

(30) Priority: 16.02.1995 BE 9500127
(43) Date of publication of application: 03.12.1997
(73) Proprietor: DSM N.V., 6411 TE Heerlen (NL)
(72) Inventor: SCHEETZ, Howard, A., Lancaster, PA 17601 (US); KOENEN, Jacob, NL-6136 EH Sittard (NL)
(86) International application number: NL9600065
(87) International publication number: WO9625463

(56) References cited:
- EP-A- 0 366 194
- EP-A- 0 382 277
- EP-A- 0 441 423
- CHEMICAL ABSTRACTS, vol. 114, no. 10, 11 March 1991 Columbus, Ohio, US; abstract no. 83229, YASUE, KENJI ET AL: "Glass fiber-reinforced nylon 46-nylon 6/66 blends with good gloss and strength and heat resistance" XP002008651 & JP,A,02 055 764 (YASUE, KENJI;IBUKI, HIROSHI; TSUJI, TOSHIO; HAYASE, SHIGERU)

## Description

The invention relates to a process for the preparation of a polyamide composition containing polyamide 4.6 and at least one second polyamide that is at least partly immiscible with polyamide 4.6, as well as to the polyamide composition obtainable by such process.

Such polymer compositions present problems when being processed, one such problem being the so-called Barus effect in extrusion, which makes it very difficult, if not impossible, to produce a uniform granulate. Articles made from the above-mentioned known compositions often possess inferior properties compared with the basic polyamides. Several methods are known to meet these objections by adding a third, non-polyamide component. Examples are found in EP-A-366194 and JP-A-03059073, where an acid-modified polyolefin is used as third component.

In particular, EP-A-366194 discloses generally compositions comprising PA-4.6 and other polyamides such as PA-6 or PA-66 in combination with PA6/6.6 (copolyamide), all compositions containing a third non-polyamide component. It is also disclosed that with a composition exclusively containing PA-6, PA-66 or a PA6/66 copolymer with PA-46 either the Barus effect is observed, which makes it very difficult to produce a uniform granulate, or the blow mouldability is low.

EP-A-0382277 teaches that improved properties are obtained if the composition contains an excess of amine terminal groups, which can be achieved, inter alia, by addition of an amine. This patent publication also discloses that the superior properties reported for compositions of polyamide 4.6 with polyamide 6 in JP-A-6106475 cannot be reproduced without an extra, apparently undisclosed measure.

Also, EP-A-441423 discloses compositions comprising PA-4.6, an aliphatic polyamide having a methylene group / amine group ratio R (= CH₂/NHCO) from 6 to 11 and a non-crystalline polyamide, which may be a copolyamide. Said publication is concerned with the reduction of the water absorption by PA-4.6, a problem different from the problem of the present invention.

The measure reported in EP-A-366194 and JP-A-03059073 has the disadvantage that the stiffness and chemical resistance are adversely affected; the measure from EP-A-0382277 is thwarted by the very limited availability of polyamide with an excess of amine terminal groups and by the fact that addition of the relatively volatile amines gives rise to technical and environmental problems.

The object of the invention now is a process for the preparation of a polyamide composition as well as a polyamide composition, containing polyamide 4.6 and at least one second polyamide that is at least partly immiscible with polyamide 4.6, which does not exhibit these disadvantages; which means it can suitably be processed and possesses a combination of the good properties of the constituent polyamides. Thus, for example, the high temperature properties of polyamide 4.6, the melting point and the HDT (heat deflection temperature), should be retained. It has now been found that the object of the invention is achieved if the composition also contains a copolyamide.

According to the invention, the process for the preparation of a polyamide composition comprising at least 50 wt.% of a block copolyamide of polyamides (a), (b), and (c), is characterized in that
(a) at least 20 wt.% of polyamide 4.6,
(b) at least 20 wt.% of at least one other polyamide, not being the copolyamide (c) and chosen from the group of aliphatic polyamides with a CH₂/NHCO ratio lower than 6 and semi-aromatic polyamides chosen from the group of polyamides based on 2,2,4-/2,4,5-trimethyl-1,6-hexamethylene diamine and tere- and/or isophtalic acid, 2-methyl-l,5-pentamethylene diamine and tere- and isophtalic acid and bis(3-methyl-4-aminocycloketyl)methane and isophatic acid and
(c) 2-40 wt.% of the copolyamide 6/66, the wt.% based on the sum of (a)+(b)+(c) are blended in the melt and that subsequently the resulting mixture remains in the melt at such a temperature and for a sufficient long time for the described block copolyamide to be formed.

Polyamides are polymers that contain repeating amide groups as integral parts of the main polymer chains. Polyamides can generally be formed through a condensation reaction of the dibasic acids and diamines, condensation of α,ω-amino acids, and through addition polymerization of cyclic lactams, for example ε-caprolactam. Detailed information on the various types of polyamides and their preparation can be found in Encyclopedia of Polymer Science and Engineering, Vol. 11, pp. 315-379 (1988), John Wiley and Sons Inc., and the references cited there.

Polyamide 4.6 is a linear polyamide which is composed of repeating tetramethylene adipamide units and which can be obtained through polycondensation of tetramethylene diamine and adipic acid.

One characteristic of immiscibility of polyamides is the occurrence of two peaks at roughly the same temperatures as the melting temperatures of the individual polyamides in the DSC diagram of the blend of the polyamides. A DSC diagram is the graphic representation of the energy to be supplied, at a constant heating-up rate, to a system incorporating the composition to be studied. At the location of a phase transition a heat effect will occur, which is manifested in a peak in the diagram. A sharp phase transition is manifested in a narrow peak, a gradual transition in a broad peak. The peak area is a measure of the energy required for the phase transition. In a cooling-down diagram the phase transition is manifested in the opposite direction. DSC, differential scanning calorimetry, is a technique generally applied for determination of the melting temperature and the crystallization temperature and the associated enthalpy. The temperature range is generally traversed at a standardized rate of 10 or 20°C a minute, so that data from various sources can to some extent be compared. However, no absolute value should be assigned to the quantities obtained from different sources, for there are lagging effects, dependent on equipment and sample size, in the heat transfer and these reflect the kinetics of the phase transition process. More information on DSC can be found in Kunststoff Handbuch, Volume 1, pp.712-19 (1990), Hanser Verlag, and the references cited there.

In the case of complete miscibility, there is one melting point, which is generally situated in between the melting points of the two constituent polyamides and whose location depends on the ratio between the constituent components and often exhibits an approximately linear relationship with this ratio. In a composition with an immiscible, fully amorphous polyamide, however, also only one melting peak is found, at the location of the melting point of the more crystalline polyamide, and its location is virtually independent of the composition. The area of the melting peak varies with the composition. In such a case, the presence of two separate polyamide phases can yet be established on the basis of the occurrence of two glass transitions in the torsion damping diagram.

In principle, several copolyamides are suitable for use as the third component (c) of the polyamide composition according to the invention. Preferably, such a copolyamide is miscible with the polyamide 4.6 in a broad range of concentrations. This miscibility is expressed, inter alia, in a gradual change of the tensile strength as a function of the composition. The best result is achieved if the copolyamide (c), in the concentration applied, is miscible with the polyamide 4.6.

The copolyamide (c) according to the invention is copolyamide 6/6.6, which can be obtained by copolymerization of equivalent amounts of hexamethylene diamine and adipic acid in the presence of ε-caprolactam. The 6/6.6 copolyamide is commercially available. The molecular weight of the copolyamide may vary between wide limits; the average molecular weight Mₙ for example lies between about 3000 and 50,000. Preferably, Mₙ is less than 20,000, more preferably less than 15,000. The best results are achieved if Mₙ is less than 10,000.

The polyamides (b) for the composition according to the invention are chosen from the group of aliphatic polyamides with a CH₂/NHCO ratio below 6, semi-aromatic polyamides based on 2,2,4-/2,4,5-trimethyl-1,6-hexamethylene diamine and tere- and/or isophthalic acid, 2-methyl-1,5-pentamethylene diamine and tere- and isophthalic acid and bis(3-methyl-4-aminocyclohexyl) methane and isophthalic acid. Such polyamides are commercially available. Of these, polyamide 6 and 6.6 are most preferred in view of their broad availability.

A large variation in properties can be achieved by applying a combination of two or more polyamides as second polyamide (b).

The polyamide 4.6 (a) content and the content of the second polyamide (b) are at least 20 wt.% and preferably between 20 and 78 wt.%. The copolyamide (c) content lies between 2 and 40 wt.%, and preferably between 2 and 20 wt.%. All percentages relate to (a)+(b)+(c) = 100%. Depending on the allowable cost price and the desired combination of properties of the polyamide composition, one skilled in the art will be able to find the optimum weight ratio for his specific case through systematic research. In general, the polyamide 4.6 (a) content will at least be equal to the polyamide (b) content.

There are in principle no restrictions as the choice of the molecular weight of the polyamides (a) and (b); Mₙ (number average molecular weight) for example lies between 5000 and 50,000. Preferably, the molecular weights chosen are high enough to obtain a polyamide composition that can directly be processed into an end product. For processing by means of injection moulding a lower molecular weight, resulting in a lower melt viscosity, will be required than for, for example extrusion blow moulding of, for example, film, or for extrusion of so-called stock shapes, such as bars and sheets.

Sometimes it is advantageous for extrusion (blow moulding) applications to subject the polyamide composition according to the invention to further heat treatment. Particularly suitable for this is a prolonged heat treatment in the solid phase at a temperature that is preferably below the melting point of the lowest-melting polyamide from the composition and in an inert gas atmosphere. As inert atmosphere nitrogen can be used, optionally enriched with water vapour to prevent any discolouring of the polyamide composition, and optionally under reduced pressure. If, for example, polyamide 6 is present as the lowest-boiling polyamide, then the heat treatment is preferably carried out at a temperature below 220°C. In principle, it is possible to carry out the heat treatment at a temperature above this lowest-melting temperature, and this is also effective, but the risk of partial demixing through (partial) melting of the lowest-melting polyamide had better be prevented. It is most surprising that this very mild heat treatment should give rise, besides an expected increase in the melt viscosity, to a strong copolymerization or transamidation, so that a significant portion of the composition is present in the form of a block copolyamide after the heat treatment. This offers the major advantage that, instead of the separate melting points of the constituent polyamides, the composition will have only one melting point, which differs little from that of polyamide 4.6, and that this gives the composition the excellent thermal properties of polyamide 4.6, even when beside the polyamide 4.6 a large amount of polyamide (b) + (c) with a substantially lower melting point is present.

The polyamide composition obtainable by the processes according to the invention forms part of this invention. Preferably, the heat treatment is continued until at least about 50 wt.% of the composition consists of the block copolyamide, and more preferably until at least 80 wt.% consists of block copolyamide; the best result is obtained if at least 90% has been converted into block copolyamide. As a measure of block polyamide formation, the melting peak area of polyamide (b) is used. If this has disappeared altogether, then (block) copolyamide formation is assumed to be 100%. If the area is 50% of the area to be expected on the basis of the polyamide (b) content, then (block) copolyamide formation is assumed to be 50%.

If the heat treatment is continued for too long, the degree of transamidation is such that the block copolyamide character is lost and statistic distribution of the copolyamide segments occurs. The melting points of such copolyamides generally lie at a low level, often even below the melting point of the lowest-melting polyamide.

A special effect of the heat treatment is that the toughness, expressed inter alia in the elongation at break, is greatly improved. Other unexpected results include the above-proportional decrease in the water absorption if the polyamide (b) is a semi-aromatic polyamide with an alkyl-substituted diamine in the units of the main chain.

With the composition according to the invention the block copolyamide can be formed also in the melt. It is highly surprising that a high degree of (block) copolyamide formation should be achieved already within a few minutes. The heat treatment in the melt is preferably carried out at a temperature above 315°C, even more preferably above 320°C. The best results are obtained at a temperature of about 325°C. The use of such high processing temperatures for polyamide 4.6 are advised against by the manufacturer in view of thermal damage to the polyamide 4.6, leading to chain rupture, discolouration, etc. Most surprising, such phenomena are not found in the composition according to the invention. As in the heat treatment in the solid phase, here too the composition must be dry and free of oxygen. To this end, the composition can for example be kept for some hours in a dry, inert gas atmosphere at elevated temperature, for example 130°C, and optionally reduced pressure. Removal of monomer and oligomeric components also offers advantages. This can simply be done by heating at about 180°C at reduced pressure.

The composition according to the invention may further contain the customary additives in concentrations that are customary for polyamide compositions, for example stabilizers, flame retardants, nucleating agents, colourants and pigments, fillers and reinforcing agents and processing auxiliaries, such as lubricating agents and mould-release agents.

The invention will now be elucidated on the basis of the following examples, without however being limited thereto.

### Example I and Comparative Experiment A

Dry and oxygen-free polyamide 4.6 and 6, in a weight ratio of 60:40, were blended at a temperature of 305°C in a twin-screw extruder. From the extrudate specimens were injection moulded at 310°C for testing of the mechanical properties (Comparative Experiment A).
The experiment was repeated, now with 5% of the polyamide 4.6 being replaced by the copolyamide 6/6.6
(Example I).
The results of mechanical testing are presented in Table 1.

### Examples II-IV

Under the same conditions as in Example I, polyamide 4.6, polyamide 6, polyamide 6.6 and copolyamide 6/6.6 were mixed and the properties of the resulting compositions were measured. The results are presented in Table 1. In columns 2-5 the properties of the individual polyamides are stated by way of reference.

The composition of Comparative Experiment A exhibited the disadvantageous properties of both polyamides, viz. the low impact strength and heat deflection temperature (HDT) of polyamide 6 and the low elongation at break of polyamide 4.6. Addition of the copolyamide resulted (Example I) in a three-fold improvement of the elongation, an almost ninefold improvement of the impact strength and a 27°C improvement of the HDT.

Example II proved that, even though all other polyamides in the composition had a lower HDT, the HDT of polyamide 4.6 could be retained for the composition.

Although the examples are limited to the use of a copolyamide 6/6.6, other copolyamides can also be used. The copolyamides are not limited to copolyamides on the basis of two polyamides. The presence of 4.6 units is not excluded, either. The weight ratio between the various constituent polyamides in the copolyamide may vary between wide limits. In the case of the 6/6.6 copolyamide, the ratio between 6 and 6.6 may vary, for example, between about 90:10 and 10:90.

### Example V

In the same way as described in Example I, a number of compositions of different types of polyamide 4.6, polyamide 6 and 6.6 and copolyamide 6/6.6 were prepared according to the invention.

The granulate obtained after extrusion was subsequently subjected to a 48-hour heat treatment at 210°C under inert gas conditions (N₂ and 8 KPa).

Properties were determined before and after the heat treatment on specimens injection moulded at 305-310°C. The compositions and results are given in Table 2.

A very remarkable finding is that in all cases toughness increases very strongly and elongation at break reaches a value of the same order of magnitude as that for polyamide 6. In almost all cases the tensile strength also improved.

If the development of the properties is monitored as a function of the duration of the heat treatment, then in general already after 6 hours a maximum appears to be reached in the properties, further continuation of the heat treatment

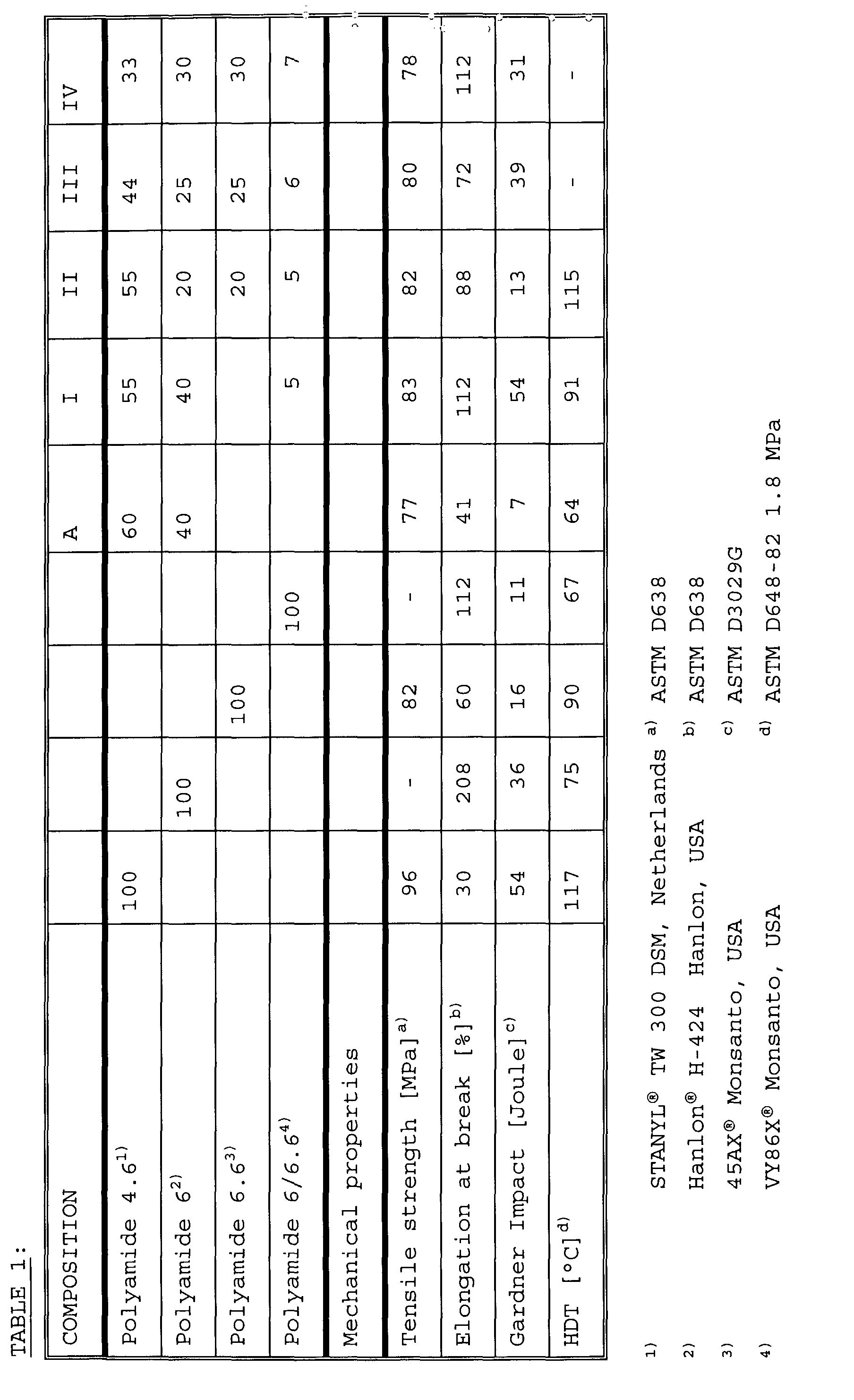

having little or no positive effect.

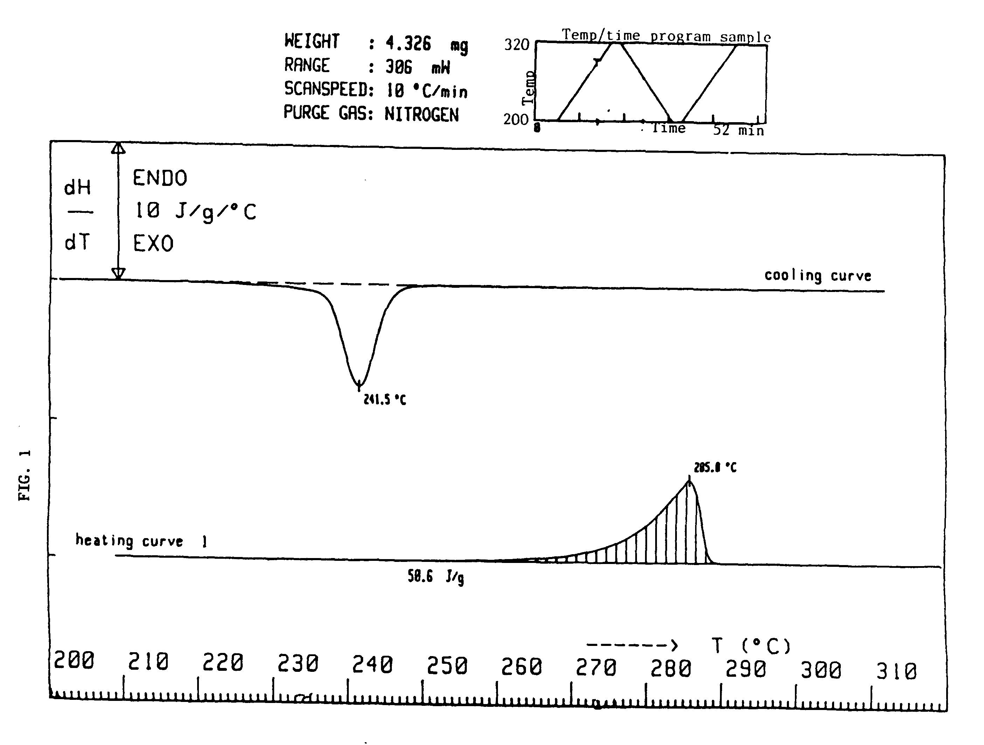

After the heat treatment all compositions in Table 2 have a single melting point that is higher than 262°C, the melting point of polyamide 6.6. Except for composition E, the compositions all have a melting temperature even in excess of 270°C. This means that, in spite of the presence of the much lower melting polyamides 6 and 6/6.6, the melting point of the composition is above that of the highest-melting polyamide (b), polyamide 6.6, while the toughness of the lowest-melting polyamide, polyamide 6, is realized. Figure 1 includes the DSC curve for composition F.

| Polyamide 4.6 | |
|---|---|
| 300 | STANYL^{®} TW 300, a medium-viscosity grade of DSM |
| 200 | STANYL^{®} TW 200, a lower-viscosity grade of DSM |

| Polyamide 6 | |
|---|---|
| MEX | AKULON^{®} MEX RP15; rel. visc. = 50.6¹; melt visc. = 5.185²; Mₙ = 18,800, from DSM, Netherlands |
| H424 | Hanlon^{®} H244; rel. visc. = 72; melt visc. = 14,500; Mₙ = 24,000, from Hanlon, USA |
| 8200 | Capron^{®} 8200; rel. visc. = 72; melt visc. = 6500, Mₙ = 28,200, from Allied, USA |

| | |
|---|---|
| ¹ measured on a solution of 10.98 g in 100 ml formic acid (ASTM D789). | |
| ² measured using a Monsanto capillary melt rheometer at 316°C and constant pressure. | |

| Polyamide 6.6 | |
|---|---|
| 45AX | obtained from Monsanto, USA |
| Z101 | Zytel^{®} 101 from DuPont, USA |

| Polyamide 6/6.6 | |
|---|---|
| VY | Vydyne^{®} VY86X, a copolyamide of 87% 6.6 and 13 wt.% 6, Mₙ = 18,700, from Monsanto, USA |

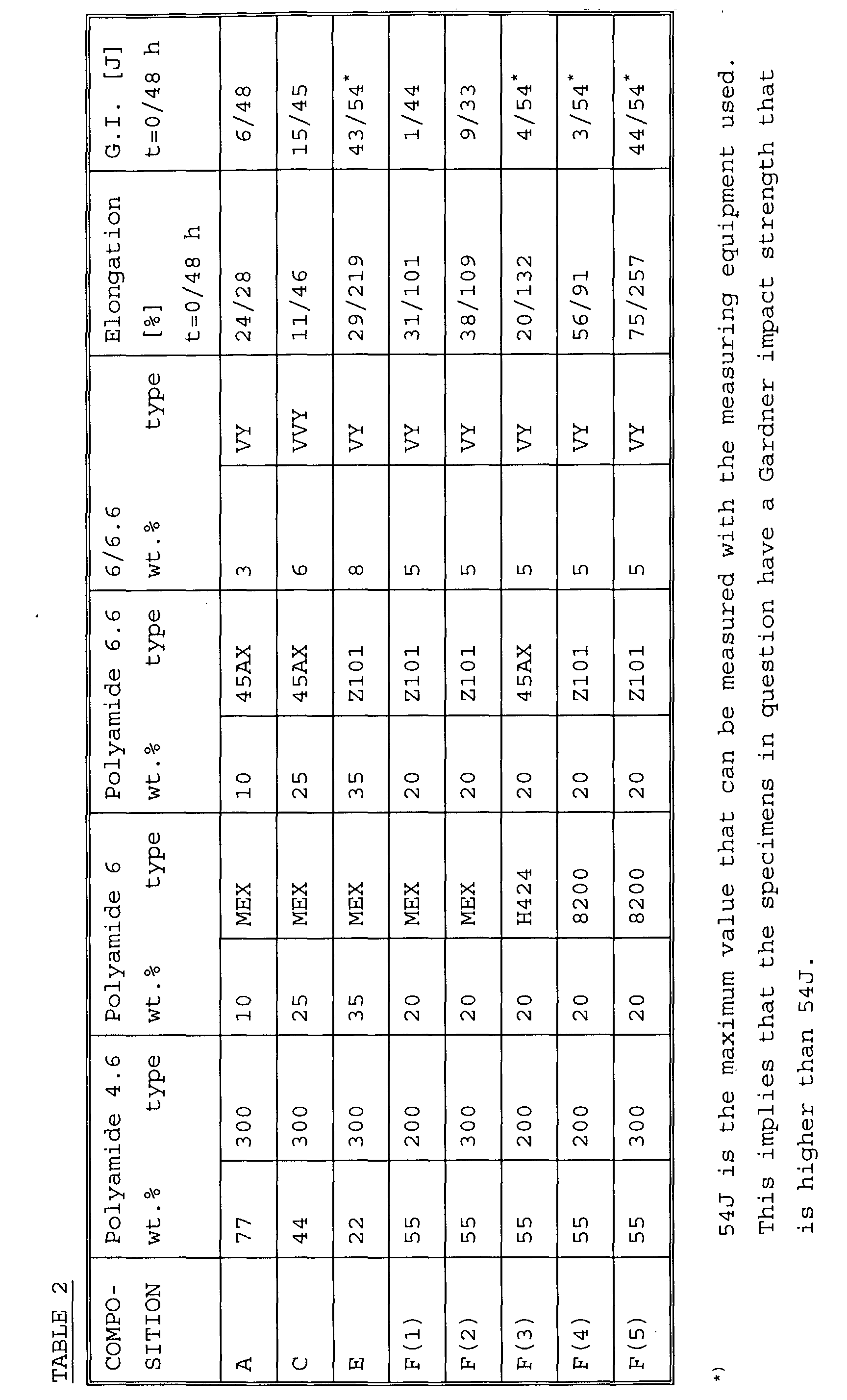

### Example VI

A composition of
55 wt.% polyamide 4.6 (STANYL^{®} KS 400)
20 wt.% polyamide 6 (Akulon^{®} S240-C)
20 wt.% polyamide 6.6 (Akulon^{®} F244)
5 wt.% polyamide 6/6.6 (Akulon^{®} R 9225-AUGH)
and 0.7 parts by weight of CuI/KI per 100 parts by weight of polyamide was mixed on a ZSK 40 twin-screw extruder at 305°C. Specimens were injection moulded from the granulate, the residence times in the melt and the melt temperature being varied.
The DSC curves were determined of both the specimens and the granulate. Table 3 gives the various residence times and temperatures in injection moulding as well as the melting temperatures, Tm, measured (1st heating-up curve as in Example V), the melting enthalpies, ΔHₘ, the E-moduli and the elongation at break, EB.

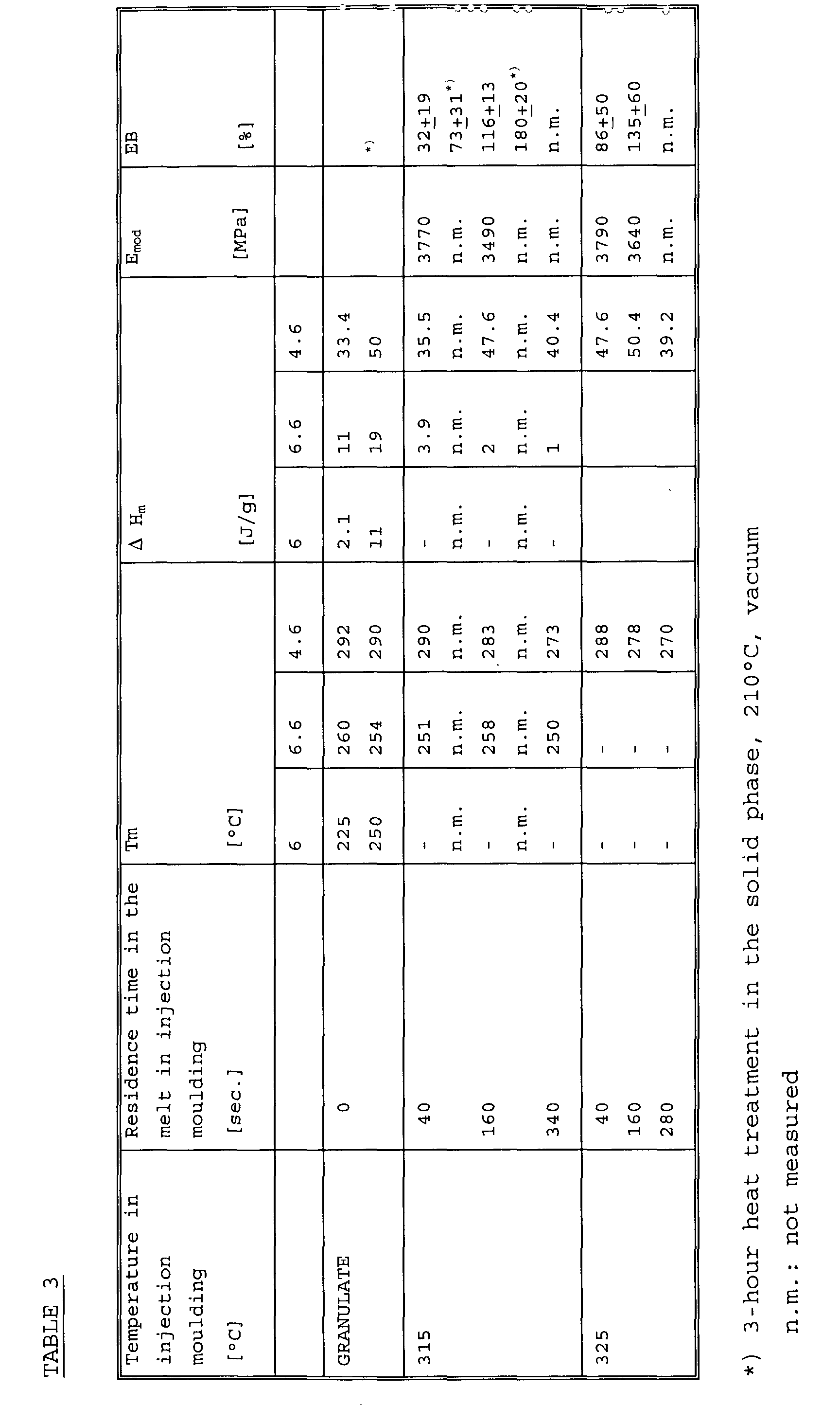

From these DSC diagrams it can be concluded that the crystalline behaviour of polyamide 4.6 is retained in the composition while, due to progressive transamidation, that of the other polyamides disappears. What is special is that, in spite of this progressive transamidation, a high melting point is retained, so that in practice this process for the preparation of the block copolyamide in the melt can suitably be applied to block copolyamides based on polyamide 4.6.
It is surprising that, contrary to what is generally thought, namely that polyamide 4.6 is seriously damaged when processed at a temperature above 320°C, with the composition according to the invention now a very tough product should be obtained.

### Example VII, Comparative Experiments B, C and D

Using a twin-screw extruder a number of semi-aromatic polyamides are blended with polyamide 4.6 and then pelletized. The extrusion temperature is 300°C. From the compositions specimen bars are injection moulded (melt temperature 315°C, residence time 45 sec.) for mechanical testing using a torsion balance. The compositions and results are presented in Table 4.

**TABLE 4**

| | Composition | | | |
|---|---|---|---|---|
| | PA 4.6/PA(b)/PA(c) wt.% | Tg °C | Tₘ₂ °C | EB % |
| B | 60/40/0 | 82/146 | 288 | 12 |
| VII | 55/40/5 | 95/146 | 288 | 18/43^{*)} |
| C | 70/30/0 | 113 | 277 | 4/5^{*)} |
| D | 70/30/0 | 120 | 239 | 15 |
| B. PA(b) = Trogamid T^{®}, polytrimethyl hexamethylene terephthalamide | | | | |
| VII. PA(b) = Trogamid T^{®}, PA(c) = PA 6/6, Vydyne VY86X^{®} | | | | |
| C. PA(b) = Grilamid TR55^{®}, copolyamide of hexamethylene diamine and tere- and isophthalic acid | | | | |
| D. PA 6.6 (70%) /Trogamid T^{®} (30%) | | | | |
| PA 4.6 = Stanyl TW 300^{®} | | | | |
| PA 6.6 = Utramid A5^{®} | | | | |

| | | | | |
|---|---|---|---|---|
| ^{*}) After 48 hours at 210°C. | | | | |

The results point to demixing for PA 4.6 and Trogamid T and mixing in Comparative Experiments C and D.

Use of copolyamide (c) in Example VII yields a positive effect on the elongation at break. In addition, the melt viscosity of the composition according to the invention (Ex. VII) appears to be substantially higher than that of the composition of Comparative Experiment C and that of polyamide 4.6. The more-than-proportional decrease in water absorption is quite unexpected. For the composition of Example VII this is 1 wt.%, versus 3.2 wt.% for PA 4.6 upon being submerged in water of 23°C for 24 hours.

The compositions according to the invention are particularly suitable for the production of films that are to meet high demands with respect to thermal properties and conservation of elongation at break upon exposure to high temperatures. Such films form part of this invention. In particular, such films are applied in so-called flexible printed circuits that must be able to withstand the high temperature of flow soldering and infra-red soldering techniques. At the moment only high performance polymers are used in this application, and it is relatively difficult, and thus expensive, to process these into films. Often use must be made of a solution of the polymer. Examples of polymers presently used are polyimide, polyetherimide, polyethersulphone andpolyetheresterketon; PI, PEI, PES and PEEK respectively. Other applications of films according to the invention are in packaging material for foodstuffs to be sterilized at a high temperature, in protective film for, for example, instruments in in-situ foamed polyurethane packagings with water as foaming agent, and in protective film for moulds for (vacuum) forming of, for example, airplane wing components using the composite back curing technique, in which very high demands are to be met as regards the conservation of high elongation under thermal load.

JP-A-63 325318 mentions the use of polyamide 4.6 films in flexible printed circuits (FPC). According to this patent publication, besides polyamide 4.6 homopolymer, copolymer with a second polyamide or a blend of polyamide 4.6 with a second polyamide can be used. The content of tetramethylene adipamide units must at least be 60 wt.% for the blends and 80 wt.% for the copolyamide. The examples are limited to homopolyamide 4.6 films.
However, the polyamide 4.6 film according to this known state of the art has a too low elongation at break.

In addition, the film may contain the customary additives, for example fillers, for example talc, colourants, release agents and stabilizers. For good processing into thin films, the melt viscosity of the polyamide composition is preferably at least 500 Pa.sec, even more preferably at least 600 Pa.sec. Depending on the processing method, in some cases even higher melt viscosities, for example 700 and 800 Pa.sec, deserve further preference.

The desired level of the melt viscosity can be chosen by means of the appropriate molecular weight of the constituent polyamides. For very high melt viscosities it is to be preferred to use the compositions that have undergone a thermal aftertreatment in the solid phase under an inert gas atmosphere or in the melt, as described previously.

The films according to the invention can be obtained using the customary techniques. Highly suitable are the extrusion (casting) technique and the blown-film technique. For specific application, coextrusion, calendering and slicing are eligible, among others. An extensive description of these techniques can be found in Encyclopedia of Polymer Science and Engineering, Vol. 7, pp. 88-127, John Wiley & Sons (1987), ISBN-0-471-80649-7 (v. 7), and the references included therein.

The invention will now be elucidated on the basis of the following examples, without however being limited thereto.

### Examples VIII and IX, comparative experiments E and F

From the composition F(5) of Example V, after a 48-hour heat treatment, a film was produced by means of casting extrusion. The processing conditions were: apparatus, flat film extruder Gottfort P-616 with 'coat-hanger' die, width 300 mm, vertical injection, extrusion temperature 305°C, throughput 9 kg/h, cooling roll temperature 100°C, winding-up speed for 25/50/100 µm film 25/24/7 m/min, respectively (Example VIII). The experiment was repeated with the composition of Example VI.
This composition was mixed in an extruder at 325°C, residence time 3 min., and then processed into film.
By way of comparative experiment film was made in an identical manner from special film quality polyamide 6 and 6.6, Akulon^{®} F135-C and S240-C, respectively. The extruder temperature used was about 250°C and 280°C, respectively.
In all cases a clear film without defects was obtained. Of the films obtained the properties were measured. The results are presented in Table 5 for the 50 µm film (after conditioning for 38 hours at 23°C and 50% relative humidity),

**TABLE 5**

| | Ex. VIII | IX | PA 6.6 | PA 6 | PA 4.6 |
|---|---|---|---|---|---|
| elongation at break [%] | 389 | 400 | 404 | 343 | 294 |
| tensile strength [MPa] | 99 | 88 | 118 | 108 | 91 |
| dielectric strength kV/mm | 159 | | | | |
| oxygen permeability ^{*}) | 1.4 | 1.5 | 2.0 | 2.3 | 1.2 |

| | | | | | |
|---|---|---|---|---|---|
| ^{*}) [10⁻⁹ cm³.cm/sec/bar] ISO 1339 (B5903, section A17) Compared with polyamide 6.6 and 6 the oxygen permeation is significantly reduced. | | | | | |

### Example X

With the composition of Example VIII a 50 µm film was produced on a lab-scale Brabender extruder with blown-film equipment. The elongation at break of this film was 285% and its tensile strength 85 MPa.

### Example XI

The film of example IX, 50 µm, was exposed to the air for four hours at 175°C and at 225°C. Before and after exposure the tensile strength and elongation at break were measured.

| | t = 0 | t = 4 | |
|---|---|---|---|
| | | 175°C | 225°C |
| tensile strength, MPa | 88 | 83 | 50 |
| elongation at break, % | 400 | 360 | 140 |

This example proves that the film retains an elongation at break of more than 100% even under the most extreme thermal load, making it very suitable for use as protective film in composite back curing.

The composition according to the invention is also suitable for the production of articles obtained by forming from the melt. Particularly if special requirements in terms of toughness and high-temperature resistance are to be met, the composition, that also exhibits the relatively high crystallization rate of polyamide 4.6, appears to offer advantages.
A special application in this context is that in monofilaments used in grass and weed trimming equipment, in which the filament may be exposed to local high temperatures and retention of toughness and tensile strength under these conditions is desirable. Especially the composition in Example VII that has excellent spinning properties offers good possibilities in this respect.
Although the majority of the examples is limited to the linear polyamides 6, 6.6 and 6/6.6, it will be evident to one skilled in the art that in principle other polyamides, too, are eligible for the compositions according to the invention and their application in products, films and fibres formed from the melt.

## Claims

1. Process for the preparation of a polyamide composition, comprising at least 50 weight% of a blockcopolyamide of polyamides (a), (b) and (c), characterised in that
(a) at least 20 wt.% of polyamide 4.6,
(b) at least 20 wt.% of at least one other polyamide, not being the copolyamide (c) and chosen from the group of aliphatic polyamides with a CH₂/NHCO ratio lower than 6 and semi-aromatic polyamides chosen from the group of polyamides based on 2,2,4-/2,4,5-trimethyl-1,6-hexamethylene diamine and tere- and/or isophtalic acid, 2-methyl-1,5-pentamethylene diamine and tere- and isophtalic acid and bis(3-methyl-4-aminocyclohexyl)methane and isophtalic acid and
(c) 2-40 wt.% of the copolyamide 6/66, the weight% based on the sum of (a)+(b)+(c) are blended in the melt and that subsequently the resulting mixture remains in the melt at such a temperature and for a sufficiently long time for the desired block copolyamide to be formed.

2. Process according to claim 1, characterised in that the temperature is chosen above 315°C, preferably above 320°C.

3. Process for the preparation of a polyamide composition, comprising at least 50 weight% of a blockcopolyamide of polyamides (a), (b) and (c), characterised in that
(a) at least 20 wt.% of polyamide 4.6,
(b) at least 20 wt.% of at least one other polyamide, not being the copolyamide (c) and chosen from the group of aliphatic polyamides with a CH₂/NHCO ratio lower than 6 and semi-aromatic polyamides chosen from the group of polyamides based on 2,2,4-/2,4,5-trihexamethylene diamine and tere- and/or isophtalic acid, 2-methyl-1,5-pentamethylene diamine and tere- and isophtalic acid and bis(3-methyl-4-aminocyclohexyl)methane and isophtalic acid and
(c) 2-40 wt.% of the copolyamide 6/66, the weight% based on the sum of (a)+(b)+(c) are blended in the melt and that subsequently, in the solid phase and at a temperature that is below the melting point of the lowest-melting polyamide, the composition is heated in an inert atmosphere for a sufficiently long time for the desired block copolyamide to be formed.

4. Process according to anyone of claims 1-3, characterised in that copolyamide (c) has a number average molecular weight of less than 20,000.

5. Polyamide composition, obtainable by the process according to any one of claims 1-4.

6. Film, fibre or article, obtainable from the polyamide composition according to claim 5.

## Patentansprüche

1. Verfahren zur Herstellung einer Polyamidzusammensetzung, umfassend mindestens 50 Gew.-% eines Blockcopolyamids der Polyamide (a), (b) und (c), dadurch gekennzeichnet, dass
(a) mindestens 20 Gew.-% von Polyamid 4,6,
(b) mindestens 20 Gew.-% von mindestens einem anderen Polyamid, welches nicht das Copolyamid (c) ist, und ausgewählt aus der Gruppe der aliphatischen Polyamide mit einem CH₂/NHCO Verhältnis niedriger als 6 und halbaromatischen Polyamide, ausgewählt aus der Gruppe der Polyamide basierend auf 2,2,4-/2,4,5-Trimethyl-1,6-hexamethylendiamin und Tere- und/oder Isophthalsäure, 2-Methyl-1,5-pentamethylendiamin und Tere- und Isophthalsäure und Bis(3-methyl-4-aminocyclohexyl)methan und Isophthalsäure und
(c) 2-40 Gew.-% des Copolyamids 6/66,
die Gew.-% basierend auf der Summe von (a)+(b)+(c),
in der Schmelze vermischt werden und das nachfolgend das sich ergebende Gemisch bei solch einer Temperatur und für eine ausreichend lange Zeit in der Schmelze verbleibt, damit sich das gewünschte Blockcopolyamid bildet.

2. Verfahren gemäss Anspruch 1, dadurch gekennzeichnet, dass die Temperatur über 315°C, vorzugsweise über 320°C gewählt wird.

3. Verfahren für die Herstellung einer Polyamidzusammensetzung, umfassend mindestens 50 Gew.-% eines Blockcopolyamids der Polyamide (a), (b) und (c), dadurch gekennzeichnet, dass
(a) mindestens 20 Gew.-% von Polyamid 4,6,
(b) mindestens 20 Gew.-% von mindestens einem anderen Polyamid, welches nicht das Copolyamid (c) ist, und ausgewählt aus der Gruppe der aliphatischen Polyamide mit einem CH₂/NHCO Verhältnis niedriger als 6 und halbaromatischen Polyamide, ausgewählt aus der Gruppe der Polyamide, basierend auf 2,2,4-/2,4,5-Trimethyl-1,6-hexamethylendiamin und Tere- und/oder Isophthalsäure, 2-Methyl-1,5-pentamethylendiamin und Tere- und Isophthalsäure und Bis(3-methyl-4-aminocyclohexyl)methan und Isophthalsäure und
(c) 2-40 Gew.-% des Copolyamids 6/66,
die Gew.-% basierend auf der Summe von (a)+(b)+(c),
in der Schmelze vermischt werden und das nachfolgend in der festen Phase und bei einer Temperatur, die unterhalb des Schmelzpunkts des am niedrigsten schmelzenden Polyamids liegt, die Zusammensetzung in einer inerten Atmosphäre für eine ausreichend lange Zeit erhitzt wird, damit sich das gewünschte Blockcopolyamid bildet.

4. Verfahren gemäss einem der Ansprüche 1-3, dadurch gekennzeichnet, dass Copolyamid (c) ein Molekulargewicht-Zahlenmittel von weniger als 20000 hat.

5. Polyamidzusammensetzung, welche durch das Verfahren gemäss einem der Ansprüche 1-4 erhältlich ist.

6. Film, Faser oder Artikel, welcher aus der Polyamidzusammensetzung gemäss Anspruch 5 erhältlich ist.

## Revendications

1. Procédé pour la préparation d'une composition de polyamide, qui comprend au moins 50 % en poids d'un copolyamide séquencé des polyamides (a), (b) et (c), caractérisé en ce que
(a) au moins 20 % en poids de polyamide 4.6,
(b) au moins 20 % en poids d'au moins un autre polyamide, qui n'est pas le copolyamide (c) et est choisi dans le groupe des polyamides aliphatiques avec un rapport CH₂/NHCO inférieur à 6 et des polyamides semi-aromatiques choisis dans le groupe des polyamides à base de 2,2,4-/2,4,5-triméthyl-l,6-hexaméthylènediamine et d'acide téré- et/ou isophtalique, de 2-méthyl-l,5-pentaméthylène-diamine et d'acides téré- et isophtaliques et de bis(3-méthyl-4-amino-cyclohexyl)méthane et d'acide isophtalique, et
(c) 2 à 40 % en poids de copolyamide 6/66,
les pourcentages pondéraux étant basés sur la somme de (a) + (b) + (c),
sont mélangés dans la masse fondue et en ce qu'ensuite le mélange résultant reste dans la masse fondue à une température telle et pendant un temps suffisamment long pour que le copolyamide séquencé souhaité soit formé.

2. Procédé selon la revendication 1, caractérisé en ce que la température est choisie au-dessus de 315°C, de préférence au-dessus de 320°C.

3. Procédé pour la préparation d'une composition de polyamide, qui comprend au moins 50 % en poids d'un copolyamide séquencé des polyamides (a), (b) et (c), caractérisé en ce que :
(a) au moins 20 % en poids de polyamide 4.6,
(b) au moins 20 % en poids d'au moins un autre polyamide, qui n'est pas le copolyamide (c) et est choisi dans le groupe des polyamides aliphatiques avec un rapport CH₂/NHCO inférieur à 6 et des polyamides semi-aromatiques choisis dans le groupe des polyamides à base de 2,2,4-/2,4,5-triméthyl-1,6-hexaméthylènediamine et d'acide téré- et/ou isophtalique, de 2-méthyl-1,5-pentaméthylène-diamine et d'acides téré- et isophtaliques et de bis(3-méthyl-4-amino-cyclohexyl)méthane et d'acide isophtalique, et
(c) 2 à 40 % en poids de copolyamide 6/66,
les pourcentages pondéraux étant basés sur la somme de (a) + (b) + (c), sont mélangés dans la masse fondue et en ce qu'ensuite, dans la phase solide et à une température qui est au-dessous du point de fusion du polyamide à plus bas point de fusion, la composition est chauffée dans une atmosphère inerte pendant un temps suffisamment long pour que le copolyamide séquencé souhaité soit formé.

4. Procédé selon l'une quelconques des revendications 1-3, caractérisé en ce que le copolyamide (c) possède une masse moléculaire moyenne en nombre inférieure à 20.000.

5. Composition de polyamide, pouvant être obtenue par le procédé selon l'une quelconque des revendications 1 à 4.

6. Film, fibre ou article, pouvant être obtenu à partir de la composition de polyamide selon la revendication 5.
